# EUROPEAN PATENT SPECIFICATION

(11) **EP 2 860 821 B1**
(45) Date of publication and mention of the grant of the patent: **04.12.2019**
(21) Application number: 14187751.4
(22) Date of filing: 06.10.2014
(51) Int. Cl.: H01Q 1/48, H01Q 13/20, H01P 5/02, H05K 1/02

(54) **Millimeter-wave broadband transition of microstrip line on thin to thick substrates**
Millimeterwellen-Breitbandübergang einer Mikrostreifenleitung von dünnen zu dicken Substraten
Transition à large bande à ondes millimétriques de ligne microruban pour substrats mince à épais

(30) Priority: 08.10.2013 US 201314048742
(43) Date of publication of application: 15.04.2015
(73) Proprietor: BlackBerry Limited, Waterloo, ON N2K 0A7 (CA)
(72) Inventor: Ghassemi, Nasser, Montreal, Québec H3S 2N3 (CA); Kanj, Houssam, Waterloo, Ontario N2K 0A7 (CA); Devries, Christopher Andrew, St. Thomas, Ontario N5P 3S9 (CA); Gu, Huanhuan, Waterloo, Ontario N2K 0A7 (CA)
(74) Representative: MERH-IP Matias Erny Reichl Hoffmann Patentanwälte PartG mbB

(56) References cited:
- EP-A1- 0 525 810
- EP-A1- 2 120 288
- EP-A1- 2 224 535
- US-A1- 2011 241 794
- US-A1- 2013 049 880

## Description

### BACKGROUND

As integrated circuit (IC) size increases, the dimension of the IC will also increase, leading to a more expensive IC. IC designers may decrease the pitch size to reduce cost. As pitch size decreases, thinner traces (thinner transmission lines) are required on the substrate or printed circuit board (PCB) to connect to the IC.

As the thickness of substrate decreases, the width of a fifty ohm (50 Ω) microstrip line also decreases. This means that, to reach to thinner microstrip lines, the IC should be mounted on a thin substrate. A thin substrate is needed to connect to small IC pitches.

However, decreasing the thickness of the substrate causes an increase in metallic losses of the microstrip lines. As the thickness of the substrate decreases, the gain and bandwidth of most antennas decreases. Some antennas, such as broadside antennas and patch antennas, may need a thick substrate (e.g., at least 200 micrometers at 60 GHz). Wide micro strips may be precluded due to the need to provide space for routing.

Thus, there are competing interests involved in association with the thickness of the substrate.

EP0525810 A describes a microstrip transmission line structure comprising a series of connected microstrip strip sections having different widths disposed on an outside layer of a unitized multilayer circuit structure and forming a microstrip line, respective ground planes for each of the strip sections formed between insulating layers of the unitized multilayer circuit structure and respectively spaced from the associated strip sections to provide a substantially constant impedance along the length of the microstrip line, and a plurality of conductive vias for electrically interconnecting the respective ground planes.

EP2224535 relates to a high-frequency transmission line connection structure. A first laminated waveguide sub-line part includes a pair of main conductor layers that oppose each other in a thickness direction with a dielectric layer having the same thickness as a dielectric layer of a microstrip line interposed therebetween. A second laminated waveguide sub-line part includes dielectric layers thicker than the dielectric layer of the first laminated waveguide sub-line part. A laminated wavegude main-line part includes dielectric layers thicker than the dielectric layers of the second laminated waveguide sub-line part. A conversion part connected to the microstrip line is formed by integrating with an upper main conductor layer constituting the respective line parts.

US2011/241794 describes an impedance matching ground plane step, in conjunction with a quarter wave transformer section, in a printed circuit board to provide a broadband microwave matching transition from board connectors or other elements that require thin substrates to thick substrate (>quarter wavelength) broadband microwave (millimeter wave) devices. A method of constructing microwave and other high frequency electrical circuits on a substrate of uniform thickness, where the circuit is formed of a plurality of interconnected elements of different impedances that individually require substrates of different thicknesses, by providing a substrate of uniform thickness that is a composite or multilayered substrate; and forming a pattern of intermediate ground planes or impedance matching steps interconnected by vias located under various parts of the circuit where components of different impedances are located so that each part of the circuit has a ground plane substrate thickness that is optimum while the entire circuit is formed on a substrate of uniform thickness.

### BRIEF DESCRIPTION OF THE DRAWINGS

The present disclosure may be understood, and its numerous objects, features and advantages obtained, when the following detailed description is considered in conjunction with the following drawings, in which:
Figure 1 depicts a system in which the present disclosure may be implemented;
Figure 2 shows a wireless-enabled communications environment including an embodiment of a client node;
Figure 3 is a simplified block diagram of a client node comprising a digital signal processor (DSP);
Figures 4A-4C illustrate a microstrip transition from a thin substrate to a thick substrate in accordance with one or more embodiments;
Figure 5 illustrates a structure of a microstrip antenna in accordance with one or more embodiments;
Figures 6A-6C illustrate a configuration for putting two antennas close to one another in accordance with one or more embodiments; and
Figure 7 illustrates a flow chart of a method in accordance with one or more embodiments.

### DETAILED DESCRIPTION

The present disclosure is directed in general to communications systems and methods for operating same. More specifically, aspects of the disclosure are directed to transitions of one or more microstrip lines in connection with substrates or substrate sections of different thicknesses.

Embodiments are directed to a structure comprising: a first substrate section having a first thickness, a second substrate section having a second thickness different from the first thickness, a plurality of vias configured to couple a first ground plane associated with the first substrate section and a second ground plane associated with the second substrate section, and a microstrip comprising: a first section associated with the first substrate section and having a first width, a second section associated with the second substrate section and having a second width different from the first width, and a taper between the first width and the second width.

Embodiments are directed to a method for constructing a structure comprising: coupling a first ground plane associated with a first substrate section and a second ground plane associated with a second substrate section, wherein the first substrate section has a first thickness that is different from a second thickness of the second substrate section, and constructing a microstrip on a layer of the structure, wherein the microstrip comprises: a first section associated with the first substrate section and having a first width, a second section associated with the second substrate section and having a second width different from the first width, and a taper between the first width and the second width

Various illustrative embodiments of the present disclosure will now be described in detail with reference to the accompanying figures. While various details are set forth in the following description, it will be appreciated that the present disclosure may be practiced without these specific details, and that numerous implementation-specific decisions may be made to the disclosure described herein to achieve specific goals, such as compliance with process technology or design-related constraints, which will vary from one implementation to another. While such a development effort might be complex and time-consuming, it would nevertheless be a routine undertaking for those of skill in the art having the benefit of this disclosure. For example, selected aspects are shown in block diagram and flowchart form, rather than in detail, in order to avoid limiting or obscuring the present disclosure. In addition, some portions of the detailed descriptions provided herein are presented in terms of algorithms or operations on data within a computer memory. Such descriptions and representations are used by those skilled in the art to describe and convey the substance of their work to others skilled in the art.

As used herein, the terms "component," "system" and the like are intended to refer to a computer-related entity, either hardware, software, a combination of hardware and software, or software in execution. For example, a component may be, but is not limited to being, a processor, a process running on a processor, an object, an executable instruction sequence, a thread of execution, a program, or a computer. In an example, a component may be, but is not limited to being, circuitry, a process running on circuitry, an object, an executable instruction sequence, a thread of execution, a program, or a computing device. By way of illustration, both an application running on a computer and the computer itself can be a component. One or more components may reside within a process or thread of execution and a component may be localized on one computer or distributed between two or more computers.

As likewise used herein, the term "node" broadly refers to a connection point, such as a redistribution point or a communication endpoint, of a communication environment, such as a network. Accordingly, such nodes refer to an active electronic device capable of sending, receiving, or forwarding information over a communications channel. Examples of such nodes include data circuit-terminating equipment (DCE), such as a modem, hub, bridge or switch, and data terminal equipment (DTE), such as a handset, a printer or a host computer (e.g., a router, workstation or server). Examples of local area network (LAN) or wide area network (WAN) nodes include computers, packet switches, cable modems, Data Subscriber Line (DSL) modems, and wireless LAN (WLAN) access points. Examples of Internet or Intranet nodes include host computers identified by an Internet Protocol (IP) address, bridges and WLAN access points. Likewise, examples of nodes in cellular communication include base stations, relays, base station controllers, radio network controllers, home location registers (HLR), visited location registers (VLR), Gateway GPRS Support Nodes (GGSN), Serving GPRS Support Nodes (SGSN), Serving Gateways (S-GW), and Packet Data Network Gateways (PDN-GW).

Other examples of nodes include client nodes, server nodes, peer nodes and access nodes. As used herein, a client node may refer to wireless devices such as mobile telephones, smart phones, personal digital assistants (PDAs), handheld devices, portable computers, tablet computers, and similar devices or other user equipment (UE) that has telecommunications capabilities. Such client nodes may likewise refer to a mobile, wireless device, or alternatively, to devices that have similar capabilities that are not generally transportable, such as desktop computers, set-top boxes, or sensors. A network node, as used herein, generally includes all nodes with the exception of client nodes, server nodes and access nodes. Likewise, a server node, as used herein, refers to an information processing device (e.g., a host computer), or series of information processing devices, that perform information processing requests submitted by other nodes. As likewise used herein, a peer node may sometimes serve as client node, and at other times, a server node. In a peer-to-peer or overlay network, a node that actively routes data for other networked devices as well as itself may be referred to as a supernode.

An access node, as used herein, refers to a node that provides a client node access to a communication environment. Examples of access nodes include cellular network base stations and wireless broadband (e.g., WiFi, WiMAX, etc.) access points, which provide corresponding cell and WLAN coverage areas. As used herein, a macrocell is used to generally describe a traditional cellular network cell coverage area. Such macrocells are typically found in rural areas, along highways, or in less populated areas. As likewise used herein, a microcell refers to a cellular network cell with a smaller coverage area than that of a macrocell. Such micro cells are typically used in a densely populated urban area. Likewise, as used herein, a picocell refers to a cellular network coverage area that is less than that of a microcell. An example of the coverage area of a picocell may be a large office, a shopping mall, or a train station. A femtocell, as used herein, currently refers to the smallest commonly accepted area of cellular network coverage. As an example, the coverage area of a femtocell is sufficient for homes or small offices.

In general, a coverage area of less than two kilometers typically corresponds to a microcell, 200 meters or less for a picocell, and on the order of 10 meters for a femtocell. The actual dimensions of the cell may depend on the radio frequency of operation, the radio propagation conditions and the density of communications traffic. As likewise used herein, a client node communicating with an access node associated with a macrocell is referred to as a "macrocell client." Likewise, a client node communicating with an access node associated with a microcell, picocell, or femtocell is respectively referred to as a "microcell client," "picocell client," or "femtocell client."

The term "article of manufacture" (or alternatively, "computer program product") as used herein is intended to encompass a computer program accessible from any computer-readable device or media, e.g., machine readable media. For example, computer readable media can include but are not limited to magnetic storage devices (e.g., hard disk, floppy disk, magnetic strips, etc.), optical disks such as a compact disk (CD) or digital versatile disk (DVD), smart cards, and flash memory devices (e.g., card, stick, etc.). In an example, the machine readable media is in a tangible form capable of being detected by a machine, data being generated therefrom and such data being manipulated and transformed by a machine.

The word "exemplary" is used herein to mean serving as an example, instance, or illustration. Any aspect or design described herein as "exemplary" is not necessarily to be construed as preferred or advantageous over other aspects or designs. Those of skill in the art will recognize many modifications may be made to this configuration without departing from the scope, spirit or intent of the claimed subject matter. Furthermore, the disclosed subject matter may be implemented as a system, method, apparatus, or article of manufacture using standard programming and engineering techniques to produce software, firmware, hardware, or any combination thereof to control a computer or processor-based device to implement aspects detailed herein.

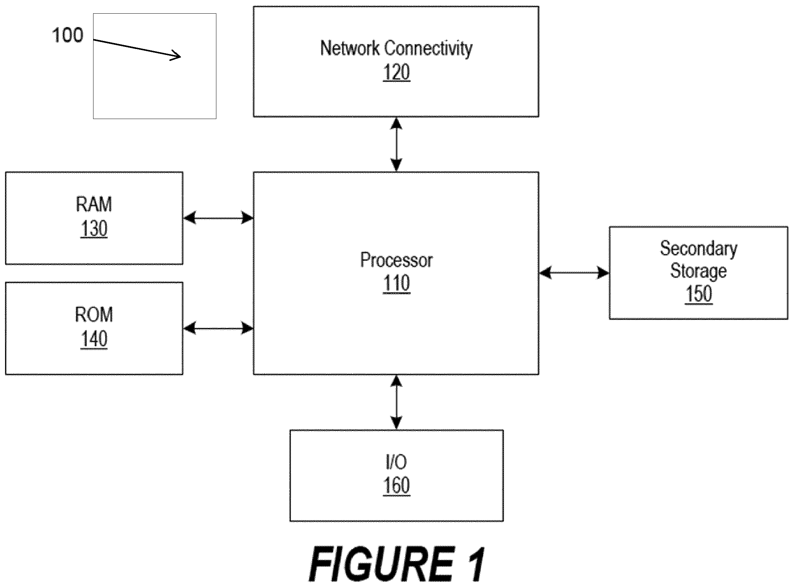

Figure 1 illustrates an example of a system 100 suitable for implementing one or more embodiments disclosed herein. In various embodiments, the system 100 comprises a processor 110, which may be referred to as a central processor unit (CPU) or digital signal processor (DSP), network connectivity interfaces 120, random access memory (RAM) 130, read only memory (ROM) 140, secondary storage 150, and input/output (I/O) devices 160. In some embodiments, some of these components may not be present or may be combined in various combinations with one another or with other components not shown. These components may be located in a single physical entity or in more than one physical entity. Any actions described herein as being taken by the processor 110 might be taken by the processor 110 alone or by the processor 110 in conjunction with one or more components shown or not shown in Figure 1.

The processor 110 executes instructions, codes, computer programs, or scripts that it might access from the network connectivity interfaces 120, RAM 130, or ROM 140. While only one processor 110 is shown, multiple processors may be present. Thus, while instructions may be discussed as being executed by a processor 110, the instructions may be executed simultaneously, serially, or otherwise by one or multiple processors 110 implemented as one or more CPU chips.

In various embodiments, the network connectivity interfaces 120 may take the form of modems, modem banks, Ethernet devices, universal serial bus (USB) interface devices, serial interfaces, token ring devices, fiber distributed data interface (FDDI) devices, wireless local area network (WLAN) devices (including radio, optical or infra-red signals), radio transceiver devices such as code division multiple access (CDMA) devices, global system for mobile communications (GSM) radio transceiver devices, long term evolution (LTE) radio transceiver devices, worldwide interoperability for microwave access (WiMAX) devices, and/or other well-known interfaces for connecting to networks, including Personal Area Networks (PANs) such as Bluetooth. These network connectivity interfaces 120 may enable the processor 110 to communicate with the Internet or one or more telecommunications networks or other networks from which the processor 110 might receive information or to which the processor 110 might output information.

The network connectivity interfaces 120 may also be capable of transmitting or receiving data wirelessly in the form of electromagnetic waves, such as radio frequency signals or microwave frequency signals. Information transmitted or received by the network connectivity interfaces 120 may include data that has been processed by the processor 110 or instructions that are to be executed by processor 110. The data may be ordered according to different sequences as may be desirable for either processing or generating the data or transmitting or receiving the data.

In various embodiments, the RAM 130 may be used to store volatile data and instructions that are executed by the processor 110. The ROM 140 shown in Figure 1 may likewise be used to store instructions and data that is read during execution of the instructions. The secondary storage 150 is typically comprised of one or more disk drives, solid state drives, or tape drives and may be used for nonvolatile storage of data or as an overflow data storage device if RAM 130 is not large enough to hold all working data. Secondary storage 150 may likewise be used to store programs that are loaded into RAM 130 when such programs are selected for execution. The I/O devices 160 may include liquid crystal displays (LCDs), Light Emitting Diode (LED) displays, Organic Light Emitting Diode (OLED) displays, projectors, televisions, touch screen displays, keyboards, keypads, switches, dials, mice, track balls, track pads, voice recognizers, card readers, paper tape readers, printers, video monitors, or other well-known input/output devices.

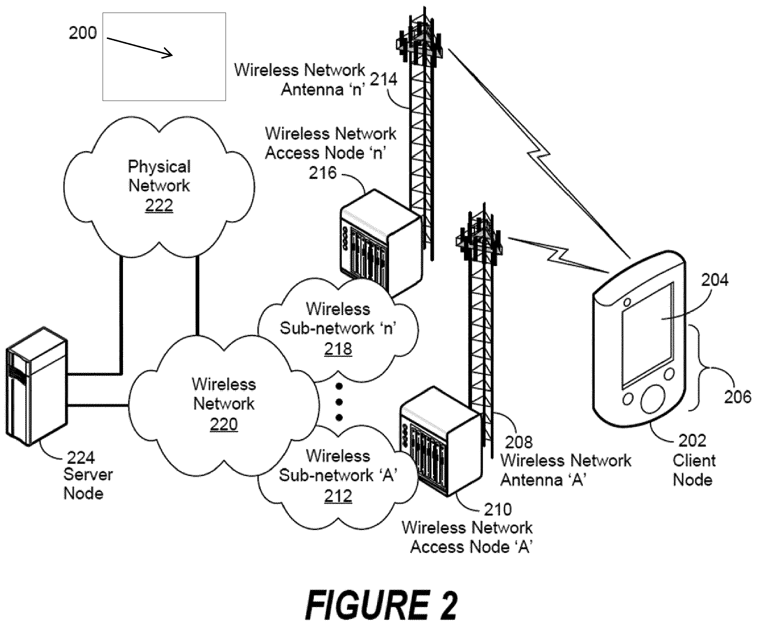

Figure 2 shows a wireless-enabled communications environment including an embodiment of a client node as implemented in an embodiment of the disclosure. Though illustrated as a mobile phone, the client node 202 may take various forms including a wireless handset, a pager, a smart phone, or a personal digital assistant (PDA). In various embodiments, the client node 202 may also comprise a portable computer, a tablet computer, a laptop computer, or any computing device operable to perform data communication operations. Many suitable devices combine some or all of these functions. In some embodiments, the client node 202 is not a general purpose computing device like a portable, laptop, or tablet computer, but rather is a special-purpose communications device such as a telecommunications device installed in a vehicle. The client node 202 may likewise be a device, include a device, or be included in a device that has similar capabilities but that is not transportable, such as a desktop computer, a set-top box, or a network node. In these and other embodiments, the client node 202 may support specialized activities such as gaming, inventory control, job control, task management functions, and so forth.

In various embodiments, the client node 202 includes a display 204. In these and other embodiments, the client node 202 may likewise include a touch-sensitive surface, a keyboard or other input keys 206 generally used for input by a user. The input keys 206 may likewise be a full or reduced alphanumeric keyboard such as QWERTY, DVORAK, AZERTY, and sequential keyboard types, or a traditional numeric keypad with alphabet letters associated with a telephone keypad. The input keys 206 may likewise include a trackwheel, an exit or escape key, a trackball, a track pad and other navigational or functional keys, which may be moved to different positions, e.g., inwardly depressed, to provide further input function. The client node 202 may likewise present options for the user to select, controls for the user to actuate, and cursors or other indicators for the user to direct.

The client node 202 may further accept data entry from the user, including numbers to dial or various parameter values for configuring the operation of the client node 202. The client node 202 may further execute one or more software or firmware applications in response to user commands. These applications may configure the client node 202 to perform various customized functions in response to user interaction. Additionally, the client node 202 may be programmed or configured over-the-air (OTA), for example from a wireless network access node 'A' 210 through 'n' 216 (e.g., a base station), a server node 224 (e.g., a host computer), or a peer client node 202.

Among the various applications executable by the client node 202 are a web browser, which enables the display 204 to display a web page. The web page may be obtained from a server node 224 through a wireless connection with a wireless network 220. As used herein, a wireless network 220 broadly refers to any network using at least one wireless connection between two of its nodes. The various applications may likewise be obtained from a peer client node 202 or other system over a connection to the wireless network 220 or any other wirelessly-enabled communication network or system.

In various embodiments, the wireless network 220 comprises a plurality of wireless sub-networks (e.g., cells with corresponding coverage areas) 'A' 212 through 'n' 218. As used herein, the wireless sub-networks 'A' 212 through 'n' 218 may variously comprise a mobile wireless access network or a fixed wireless access network. In these and other embodiments, the client node 202 transmits and receives communication signals, which are respectively communicated to and from the wireless network nodes 'A' 210 through 'n' 216 by wireless network antennas 'A' 208 through 'n' 214 (e.g., cell towers). In turn, the communication signals are used by the wireless network access nodes 'A' 210 through 'n' 216 to establish a wireless communication session with the client node 202. As used herein, the network access nodes 'A' 210 through 'n' 216 broadly refer to any access node of a wireless network. As shown in Figure 2, the wireless network access nodes 'A' 210 through 'n' 216 are respectively coupled to wireless sub-networks 'A' 212 through 'n' 218, which are in turn connected to the wireless network 220.

In various embodiments, the wireless network 220 is coupled to a core network 222, e.g., a global computer network such as the Internet. Via the wireless network 220 and the core network 222, the client node 202 has access to information on various hosts, such as the server node 224. In these and other embodiments, the server node 224 may provide content that may be shown on the display 204 or used by the client node processor 110 for its operations. Alternatively, the client node 202 may access the wireless network 220 through a peer client node 202 acting as an intermediary, in a relay type or hop type of connection. As another alternative, the client node 202 may be tethered and obtain its data from a linked device that is connected to the wireless sub-network 212. Skilled practitioners of the art will recognize that many such embodiments are possible and the foregoing is not intended to limit the spirit, scope, or intention of the disclosure.

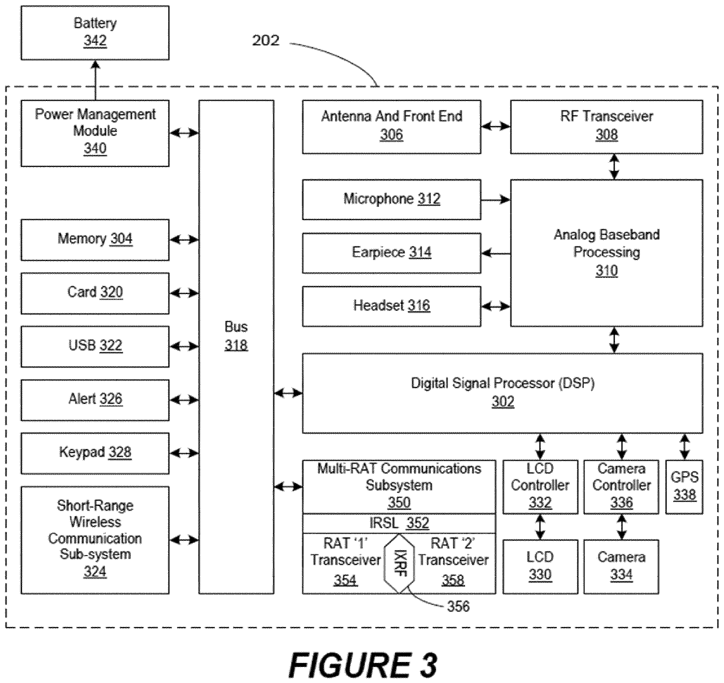

Figure 3 depicts a block diagram of an exemplary client node as implemented with a digital signal processor (DSP) in accordance with an embodiment of the disclosure. While various components of a client node 202 are depicted, various embodiments of the client node 202 may include a subset of the listed components or additional components not listed. As shown in Figure 3, the client node 202 includes a DSP 302 and a memory 304. As shown, the client node 202 may further include an antenna and front end unit 306, a radio frequency (RF) transceiver 308, an analog baseband processing unit 310, a microphone 312, an earpiece speaker 314, a headset port 316, a bus 318, such as a system bus or an input/output (I/O) interface bus, a removable memory card 320, a universal serial bus (USB) port 322, a short range wireless communication sub-system 324, an alert 326, a keypad 328, a liquid crystal display (LCD) 330, which may include a touch sensitive surface, an LCD controller 332, a charge-coupled device (CCD) camera 334, a camera controller 336, and a global positioning system (GPS) sensor 338, and a power management module 340 operably coupled to a power storage unit, such as a battery 342. In various embodiments, the client node 202 may include another kind of display that does not provide a touch sensitive screen. In one embodiment, the DSP 302 communicates directly with the memory 304 without passing through the input/output interface ("Bus") 318.

In various embodiments, the DSP 302 or some other form of controller or central processing unit (CPU) operates to control the various components of the client node 202 in accordance with embedded software or firmware stored in memory 304 or stored in memory contained within the DSP 302 itself. In addition to the embedded software or firmware, the DSP 302 may execute other applications stored in the memory 304 or made available via information media such as portable data storage media like the removable memory card 320 or via wired or wireless network communications. The application software may comprise a compiled set of machine-readable instructions that configure the DSP 302 to provide the desired functionality, or the application software may be high-level software instructions to be processed by an interpreter or compiler to indirectly configure the DSP 302.

The antenna and front end unit 306 may be provided to convert between wireless signals and electrical signals, enabling the client node 202 to send and receive information from a cellular network or some other available wireless communications network or from a peer client node 202. In an embodiment, the antenna and front end unit 106 may include multiple antennas to support beam forming and/or multiple input multiple output (MIMO) operations. As is known to those skilled in the art, MIMO operations may provide spatial diversity, which can be used to overcome difficult channel conditions or to increase channel throughput. Likewise, the antenna and front-end unit 306 may include circuitry, for example, antenna tuning or impedance matching components, RF power amplifiers, or low noise amplifiers.

In various embodiments, the RF transceiver 308 provides frequency shifting, converting received RF signals to baseband and converting baseband transmit signals to RF. In some descriptions a radio transceiver or RF transceiver may be understood to include other signal processing functionality such as modulation/demodulation, coding/decoding, interleaving/deinterleaving, spreading/despreading, inverse fast Fourier transforming (IFFT)/fast Fourier transforming (FFT), cyclic prefix appending/removal, and other signal processing functions. For the purposes of clarity, the description here separates the description of this signal processing from the RF and/or radio stage and conceptually allocates that signal processing to the analog baseband processing unit 310 or the DSP 302 or other central processing unit. In some embodiments, the RF Transceiver 108, portions of the Antenna and Front End 306, and the analog base band processing unit 310 may be combined in one or more processing units and/or application specific integrated circuits (ASICs).

Note that in this diagram the radio access technology (RAT) RAT1 and RAT2 transceivers 354, 358, the IXRF 356, the IRSL 352 and Multi-RAT subsystem 350 are operably coupled to the RF transceiver 308 and analog baseband processing unit 310 and then also coupled to the antenna and front end 306 via the RF transceiver 308. As there may be multiple RAT transceivers, there will typically be multiple antennas or front ends 306 or RF transceivers 308, one for each RAT or band of operation.

The analog baseband processing unit 310 may provide various analog processing of inputs and outputs for the RF transceivers 308 and the speech interfaces (312, 314, 316). For example, the analog baseband processing unit 310 receives inputs from the microphone 312 and the headset 316 and provides outputs to the earpiece 314 and the headset 316. To that end, the analog baseband processing unit 310 may have ports for connecting to the built-in microphone 312 and the earpiece speaker 314 that enable the client node 202 to be used as a cell phone. The analog baseband processing unit 310 may further include a port for connecting to a headset or other hands-free microphone and speaker configuration. The analog baseband processing unit 310 may provide digital-to-analog conversion in one signal direction and analog-to-digital conversion in the opposing signal direction. In various embodiments, at least some of the functionality of the analog baseband processing unit 310 may be provided by digital processing components, for example by the DSP 302 or by other central processing units.

The DSP 302 may perform modulation/demodulation, coding/decoding, interleaving/deinterleaving, spreading/despreading, inverse fast Fourier transforming (IFFT)/fast Fourier transforming (FFT), cyclic prefix appending/removal, and other signal processing functions associated with wireless communications. In an embodiment, for example in a code division multiple access (CDMA) technology application, for a transmitter function the DSP 302 may perform modulation, coding, interleaving, and spreading, and for a receiver function the DSP 302 may perform despreading, deinterleaving, decoding, and demodulation. In another embodiment, for example in an orthogonal frequency division multiplex access (OFDMA) technology application, for the transmitter function the DSP 302 may perform modulation, coding, interleaving, inverse fast Fourier transforming, and cyclic prefix appending, and for a receiver function the DSP 302 may perform cyclic prefix removal, fast Fourier transforming, deinterleaving, decoding, and demodulation. In other wireless technology applications, yet other signal processing functions and combinations of signal processing functions may be performed by the DSP 302.

The DSP 302 may communicate with a wireless network via the analog baseband processing unit 310. In some embodiments, the communication may provide global computer network (e.g., Internet) connectivity, enabling a user to gain access to content on the global computer network and to send and receive e-mail or text messages. The input/output interface 318 interconnects the DSP 302 and various memories and interfaces. The memory 304 and the removable memory card 320 may provide software and data to configure the operation of the DSP 302. Among the interfaces may be the USB interface 322 and the short range wireless communication sub-system 324. The USB interface 322 may be used to charge the client node 202 and may also enable the client node 202 to function as a peripheral device to exchange information with a personal computer or other computer system. The short range wireless communication sub-system 324 may include an infrared port, a Bluetooth interface, an IEEE 802.11 compliant wireless interface, or any other short range wireless communication sub-system, which may enable the client node 202 to communicate wirelessly with other nearby client nodes and access nodes. The short-range wireless communication Sub-system 324 may also include suitable RF Transceiver, Antenna and Front End subsystems.

The input/output interface ("Bus") 318 may further connect the DSP 302 to the alert 326 that, when triggered, causes the client node 202 to provide a notice to the user, for example, by ringing, playing a melody, or vibrating. The alert 326 may serve as a mechanism for alerting the user to any of various events such as an incoming call, a new text message, and an appointment reminder by silently vibrating, or by playing a specific pre-assigned melody for a particular caller.

The keypad 328 couples to the DSP 302 via the I/O interface ("Bus") 318 to provide one mechanism for the user to make selections, enter information, and otherwise provide input to the client node 202. The keyboard 328 may be a full or reduced alphanumeric keyboard such as QWERTY, DVORAK, AZERTY and sequential types, or a traditional numeric keypad with alphabet letters associated with a telephone keypad. The input keys may likewise include a trackwheel, track pad, an exit or escape key, a trackball, and other navigational or functional keys, which may be inwardly depressed to provide further input function. Another input mechanism may be the LCD 330, which may include touch screen capability and also display text and/or graphics to the user. The LCD controller 332 couples the DSP 302 to the LCD 330.

The CCD camera 334, if equipped, enables the client node 202 to make digital pictures. The DSP 302 communicates with the CCD camera 334 via the camera controller 336. In another embodiment, a camera operating according to a technology other than Charge Coupled Device cameras may be employed. The GPS sensor 338 is coupled to the DSP 302 to decode global positioning system signals or other navigational signals, thereby enabling the client node 202 to determine its position. The GPS sensor 338 may be coupled to an antenna and front end (not shown) suitable for its band of operation. Various other peripherals may also be included to provide additional functions, such as radio and television reception.

In various embodiments, the client node (e.g., 202) comprises a first Radio Access Technology (RAT) transceiver 354 and a second RAT transceiver 358. As shown in Figure 3, and described in greater detail herein, the RAT transceivers '1' 354 and '2' 358 are in turn coupled to a multi-RAT communications subsystem 350 by an Inter-RAT Supervisory Layer Module 352. In turn, the multi- RAT communications subsystem 350 is operably coupled to the Bus 318. Optionally, the respective radio protocol layers of the first Radio Access Technology (RAT) transceiver 354 and the second RAT transceiver 358 are operably coupled to one another through an Inter-RAT eXchange Function (IRXF) Module 356.

In various embodiments, the network node (e.g. 224) acting as a server comprises a first communication link corresponding to data to/from the first RAT and a second communication link corresponding to data to/from the second RAT.

Embodiments of the disclosure may be associated with communication at radio frequency (RF). For example, aspects of the disclosure may be used in connection with millimeter wave (mmWave) radio. In some embodiments, a 60 GHz spectrum may include one or more channels, bands or ranges. For example, a first range may be from 57.2 GHz - 59.4 GHz, a second range may be from 59.4 GHz to 61.5 GHz, a third range may be from 61.5 GHz to 63.7 GHz, and a fourth range may be from 63.7 GHz to 65.8 GHz.

A stripline refers to a transverse electromagnetic (TEM) transmission line medium that uses a flat strip of conductor/metal sandwiched between parallel ground planes. The stripline may be supported by a dielectric. A microstrip is similar to a stripline transmission except that the microstrip is not sandwiched, it is on a surface, above a ground plane.

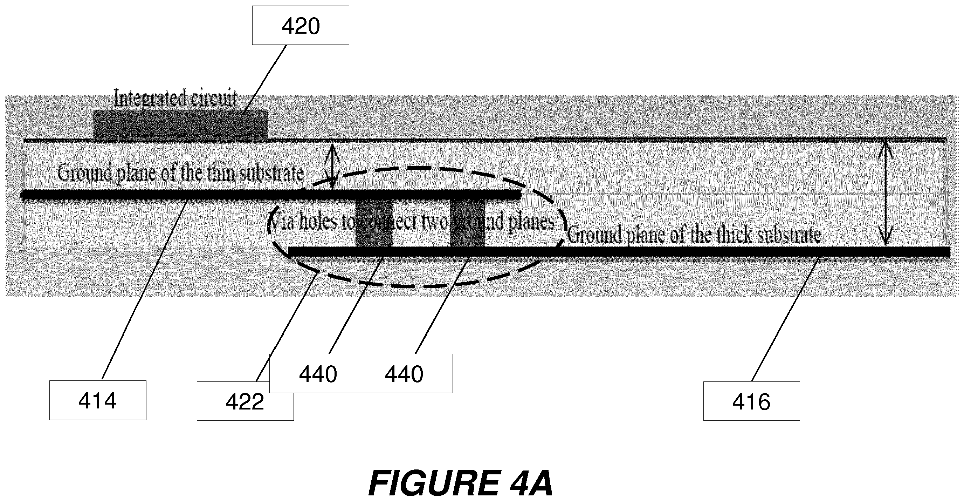

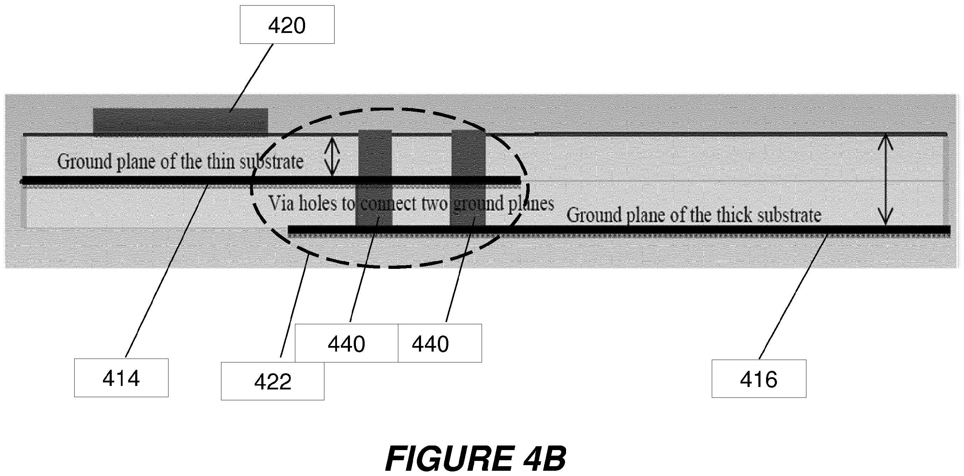

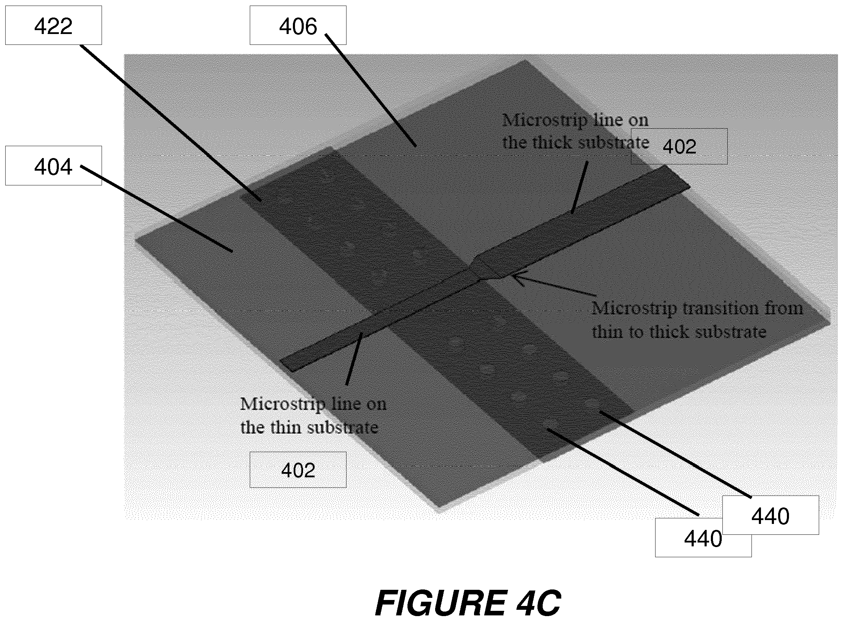

Referring generally to Figures 4A-4C (collectively referred to as Figure 4), a structure of microstrip line 402 transitioning from a first substrate section 404 to a second substrate section 406 is shown in Figure 4C. The second substrate section 406 may be thicker than the first substrate section 404. Substrate section 404 and 406 may be both fabricated on the same multi-layer substrate. The structure of FIG. 4 can be incorporated into the devices described in conjunction with and shown in FIGS 1-3. The structure of FIG. 4 can be used to transition a mmWave antenna to a different thickness substrate.

The structure of Figure 4 may contain two layers of substrate that are laminated to one another to create a multi-layer substrate. A ground plane 414 at the middle layer (e.g., the ground plane of the first substrate section 404) may be located just under an integrated circuit (IC) 420. Vias 440 may connect the ground plane 414 to a ground plane 416 of the second substrate section 406. The ground planes 414 and 416 may overlap in a section 422. On a top layer (e.g., a layer of microstrip lines 402), at the border of first substrate section 404 to second substrate section 406, a tapered transition may be used to connect, e.g., thin to thick microstrip lines.

Depending on the size of the vias 440, a single row of vias 440 may be used if via spacing is small enough. Otherwise, two rows of vias 440 may be used. In the embodiment shown in Figure 4A, blind vias 440 (e.g., vias exposed on only one side of a PCB) are used to simply connect the ground plane 414 to the ground plane 416. In the embodiment shown in Figure 4B, through-hole vias 440 are used which drill to the top and bottom substrates. If blind vias are used, they may be placed directly under the microstrip line 402 whereas if only through-hole vias are available then they may be placed at a pre-determined distance from the microstrip line 402 as shown in Figure 4. This distance may be dictated by the design rules for the PCB manufacturing.

As described above, as the thickness of substrate under an antenna (e.g., an edge feed microstrip patch antenna) increases, the gain and bandwidth may also increase. But, increasing the thickness of the substrate results in wider microstrip lines, which makes connecting the antenna to the chip problematic, due to the small size of the IC pitch. On the other hand, when the feed line of the antenna is wide and comparable to the dimensions of the antenna, the feed line may impact the radiation pattern of the antenna.

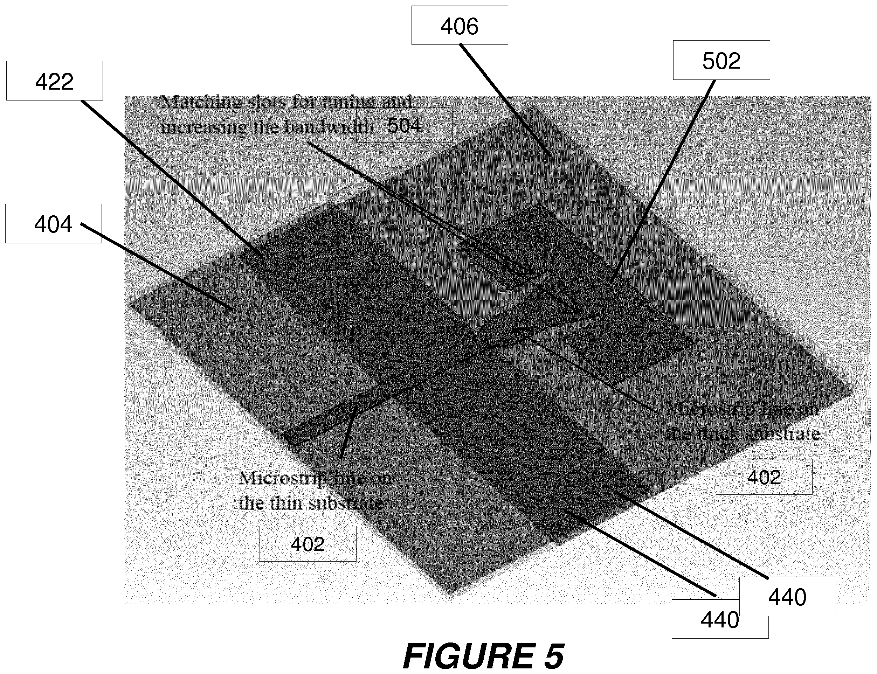

To remedy the above, a structure of a high gain and broadband E-shaped microstrip antenna 502 is shown in Figure 5. The structure shown in Figure 5 may use the transition of the microstrip 402 from first substrate section 404 to second substrate section 406 to feed the antenna 502. Using this transition can help to design the antenna 502 on thick substrate and increase the gain and bandwidth of the antenna 502, while still allowing the antenna 502 to be connected to a very small pitch size IC. Grooves may be used at the connection interface of the antenna 502 to wide microstrip lines to match the impedance of the microstrip lines to the impedance of the antenna 502.

The antenna 502 includes at least two slots 504. The slots 504 may be used for purposes of tuning and increasing the bandwidth. The wedge shaped slots 504 may cut the patch in both sides of the feed line to match the impedance of the feed line to the impedance of the patch. These slots 504 may create some other resonant frequencies in addition to the main resonant frequency of the patch. By changing the dimension of the slots 504, it is possible to place these resonant frequencies close to a main resonant frequency of the patch and then increase the bandwidth of the antenna 502.

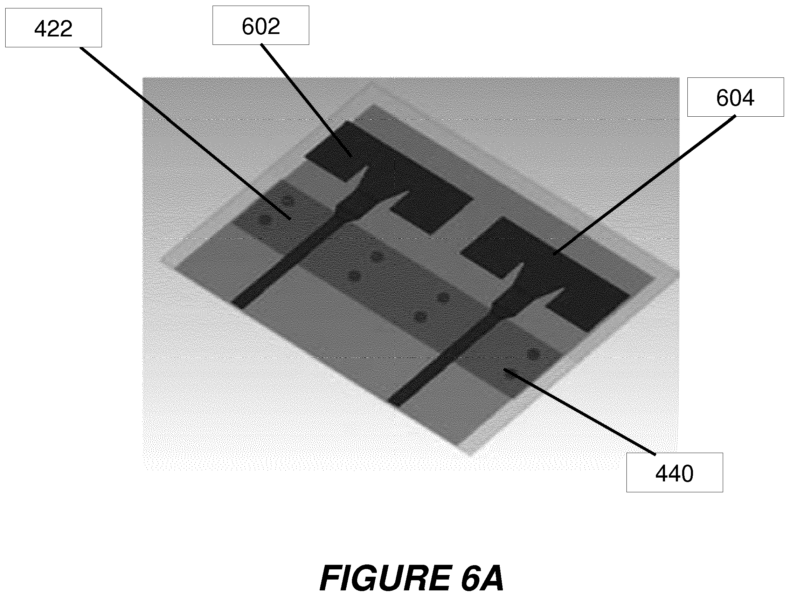

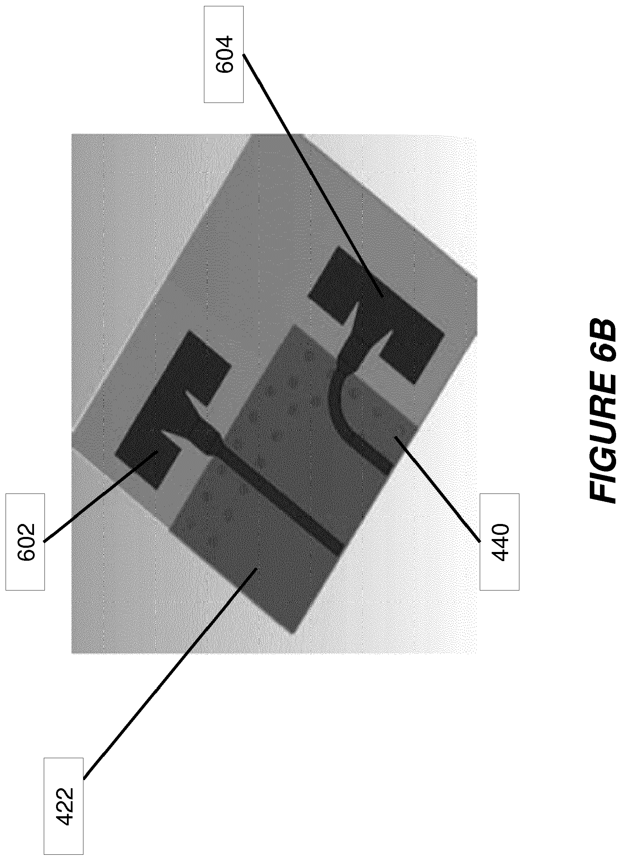

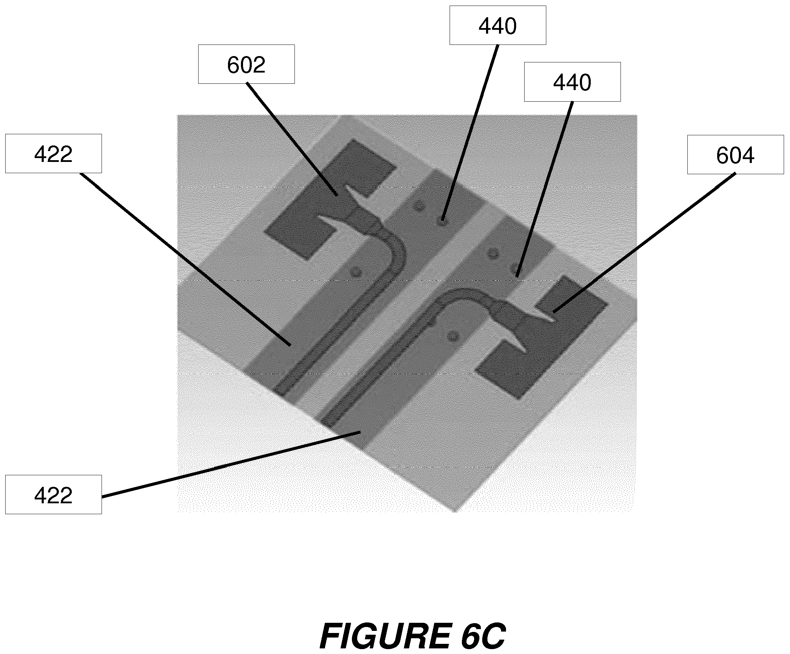

In some instances, on the structure of a microstrip line transition from, e.g., thin to thick substrate sections, such as the transition shown in Figure 5, it may be possible to reduce the number of vias 440 used. In such instances, two or more antennas may be placed close to one another. Figures 6A-6C illustrate exemplary embodiments for placing a first E-shaped antenna 602 in proximity to a second E-shaped antenna 604 using various configurations or orientations for the antenna 602 relative to the antenna 604. The second antenna 604 may be oriented at any angle (e.g., zero to three-hundred sixty degrees) relative to the first antenna 602. For example, Figure 6A may correspond to a zero degree angle between the antennas 602 and 604, Figure 6B may correspond to a ninety degree angle between the antennas 602 and 604, and Figure 6C may correspond to a one-hundred eighty degree angle between the antennas 602 and 604.

In some embodiments, a first of the antennas (e.g., antenna 602) may be used for transmission and a second of the antennas (e.g., antenna 604) may be used for reception. In some embodiments, the antennas may operate at the same time as part of a phased array antenna system.

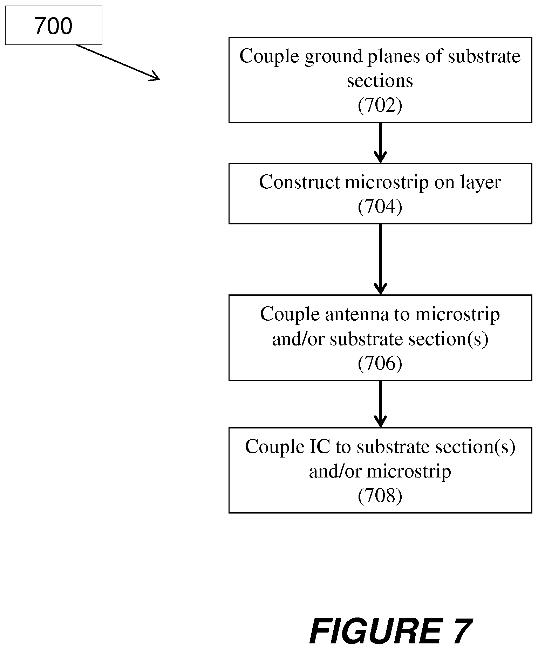

Referring to Figure 7, a flow chart of an exemplary method 700 is shown. The method 700 may execute in connection with one or more components, devices, or systems, such as those described herein. The method 700 may be used to design and implement a structure for a microstrip transition between two or more substrates or substrate sections. The resultant design may facilitate use or operation at mmWave frequencies.

In block 702, a ground plane of a first substrate section may be coupled to a ground plane of a second substrate section. The first substrate section may have a different thickness relative to the second substrate section. For example, the first substrate section may be thinner than the second substrate. The ground planes or substrate sections may be arranged such that they partially overlap in a ground coupling section (e.g., section 422).

In block 704, microstrip may be constructed or included in the structure. The microstrip may be included on a top layer of the structure. The microstrip may include one or more sections, such as a first section and a second section. The first section of microstrip may have a width that is different from the second section of microstrip (e.g., the first section of microstrip may be thinner than the second section of microstrip). The first section of microstrip may be associated with the first substrate section and the second section of microstrip may be associated with the second substrate section. At a border of thin-to-thick substrate, the microstrip may be tapered to connect thin-to-thick microstrip lines. The taper may transition between the different widths of the microstrip.

In block 706, an antenna may be coupled to the microstrip and/or one or more substrate sections. The antenna may include one or more slots, which may be used for, e.g., purposes of tuning.

In block 708, an IC may be coupled to one or more substrate sections and/or the microstrip.

The method 700 is illustrative. In some embodiments, one or more of the blocks or operations (or a portion thereof) may be optional. In some embodiments, additional blocks or operations may be included. In some embodiments, the blocks may execute in an order or sequence different from what is shown in Figure 7.

As described herein, in some embodiments various functions or acts may take place at a given location and/or in connection with the operation of one or more apparatuses, systems, or devices. For example, in some embodiments, a portion of a given function or act may be performed at a first device or location, and the remainder of the function or act may be performed at one or more additional devices or locations.

The present description references ground, e.g., ground plane(s), ground connections, etc. It will be understood that ground can be Earth or zero potential. In other examples, ground is not necessarily Earth potential, and a "ground line" or "ground plane" need not be electrically connected to the Earth. Rather, ground basically connotes a node that is maintained at a reference voltage that is substantially constant with respect to other voltages in the structures and circuitry described herein.

Embodiments of the disclosure are directed to a structure configured to operate in accordance with millimeter wave (mmWave) radio comprising: a first substrate section (404) having a first thickness; a second substrate section (406) having a second thickness different from the first thickness; a plurality of vias (440) configured to couple a first ground plane (414) associated with the first substrate section (404) and a second ground plane (416) associated with the second substrate section (406); and a microstrip (402) comprising: a first section associated with the first substrate section (404) and having a first width; a second section associated with the second substrate section (406) and having a second width different from the first width; and a taper between the first width and the second width. The vias (440) may comprise blind vias (440). The vias (440) may comprise through-hole vias (440). The first ground plane (414) and the second ground plane (416) may be configured to partially overlap one another in a ground coupling section (422), and the vias (440) may be located in the ground coupling section (422). The structure may comprise an antenna (502, 602) coupled to at least one of: the microstrip (402); and at least one of the first (404) and second (406) substrate sections. The antenna (502, 602) may comprise an E-shaped edge feed antenna (502, 602). The antenna (502, 602) may comprise matching slots (504) configured for tuning purposes. The structure may comprise a second antenna (604). The antenna (502, 602) may be configured for one of transmission and reception, and the second antenna (604) may be configured for the other of transmission and reception. The second antenna (604) may be oriented at a non-zero angle relative to the antenna (502, 602). The antenna (502, 602) and the second antenna (604) may be part of a phased array antenna system. The structure may be configured to operate in accordance with a 60 GHz spectrum.

Embodiments of the disclosure are directed to a method (700) for constructing a structure comprising: coupling (702) a first ground plane (414) associated with a first substrate section (404) and a second ground plane (416) associated with a second substrate section (406), wherein the first substrate section (404) has a first thickness that is different from a second thickness of the second substrate section (406); and constructing (704) a microstrip (402) on a layer of the structure, wherein the microstrip (402) comprises: a first section associated with the first substrate section (404) and having a first width, a second section associated with the second substrate section (406) and having a second width different from the first width, and a taper between the first width and the second width. The structure may be configured to operate in accordance with a 60 GHz spectrum comprising a plurality of frequency ranges. The method (700) may further comprise: coupling (708) an integrated circuit (IC) (420) to at least one of: the microstrip (402); and at least one of the first (404) and second (406) substrate sections; and coupling (706) an antenna (502, 602) to at least one of: the microstrip (402); and at least one of the first (404) and second (406) substrate sections.

Embodiments of the disclosure may be implemented using one or more technologies. In some embodiments, an apparatus or system may include one or more processors, and memory storing instructions that, when executed by the one or more processors, cause the apparatus or system to perform one or more methodological acts as described herein. Various mechanical components known to those of skill in the art may be used in some embodiments.

Embodiments of the disclosure may be implemented as one or more apparatuses, systems, and/or methods. In some embodiments, instructions may be stored on one or more computer-readable media, such as a transitory and/or non-transitory computer-readable medium. The instructions, when executed, may cause an entity (e.g., an apparatus or system) to perform one or more methodological acts as described herein. In some embodiments, the functionality described herein may be implemented in hardware, software, firmware, or any combination thereof.

The particular embodiments disclosed above are illustrative only and should not be taken as limitations upon the present disclosure, as the disclosure may be modified and practiced in different but equivalent manners apparent to those skilled in the art having the benefit of the teachings herein. Accordingly, the foregoing description is not intended to limit the disclosure to the particular form set forth, but on the contrary, is intended to cover such alternatives, modifications
and equivalents as may be included within the scope of the disclosure as defined by the appended claims so that those skilled in the art should understand that they can make various changes,
substitutions and alterations without departing from the scope of the disclosure in its broadest form.

## Claims

1. A structure configured to operate in accordance with millimeter wave, mmWave, radio, comprising:
a first substrate section (404) having a first thickness;
a second substrate section (406) having a second thickness different from the first thickness;
a plurality of vias (440) configured to couple a first ground plane (414) associated with the first substrate section and a second ground plane (416) associated with the second substrate section;
a microstrip feed line (402) on a layer of the structure, the microstrip feed line comprising:
a first section associated with the first substrate section (404) and having a first width;
a second section associated with the second substrate section (406) and having a second width different from the first width; and
a taper between the first width and the second width; and
an antenna (502; 602) on the layer of the structure, the antenna (502; 602) being coupled to the microstrip feed line (402) and at least one of the first substrate section (404) and the second substrate section (406), wherein the antenna comprises at least two wedge-shaped slots (504) which cut the antenna in both sides of the microstrip feed line (402).

2. The structure of claim 1, wherein the vias (440) comprise blind vias.

3. The structure of claim 1, wherein the vias (440) comprise through-hole vias.

4. The structure of claim 1, wherein the first ground plane (414) and the second ground plane (416) are configured to partially overlap one another in a ground coupling section (422), and wherein the vias (440) are located in the ground coupling section (422).

5. The structure of claim 1, wherein the antenna (502; 602) comprises an E-shaped edge feed antenna.

6. The structure of claim 1, wherein the at least two wedge-shaped slots (504) are configured for tuning purposes.

7. The structure of claim 1, further comprising:
a second antenna (604) oriented at a non-zero angle relative to the antenna (502; 602).

8. The structure of claim 1, further comprising:
a second antenna (604), the antenna (502; 602) and the second antenna (604) formed as part of a phased array antenna system.

9. The structure of claim 1, further comprising:
a second antenna (604), wherein the antenna (502; 602) is configured for one of transmission and reception and the second antenna (604) is configured for the other of transmission and reception.

10. A method for constructing a structure comprising:
coupling (702) a first ground plane (414) associated with a first substrate section (404) and a second ground plane (416) associated with a second substrate section (406), wherein the first substrate section (404) has a first thickness that is different from a second thickness of the second substrate section (406);
constructing (704) a microstrip feed line (402) on a layer of the structure, wherein the microstrip feed line (402) comprises:
a first section associated with the first substrate section (404) and having a first width,
a second section associated with the second substrate section (406) and having a second width different from the first width, and
a taper between the first width and the second width; and
constructing an antenna (502; 602) on the layer of the structure, the antenna (502; 602) being coupled to the microstrip feed line (402) and at least one of the first substrate section (404) and the second substrate section (406), wherein the antenna comprises at least two wedge-shaped slots (504) which cut the antenna in both sides of the microstrip feed line (402).

11. The method of claim 10, further comprising:
coupling the first ground plane (414) and the second ground plane (416) in a section where the first ground plane overlaps the second ground plane using a plurality of vias (440) arranged in a plurality of rows.

12. The method of claim 10, further comprising:
coupling an integrated circuit (420) to at least one of:
the microstrip feed line (402); and
at least one of the first (404) and second (406) substrate sections.

13. The method of claim 10, further comprising:
configuring the antenna (502; 602) for one of transmission and reception; and
configuring a second antenna (604) included in the structure for the other of transmission and reception.

14. The method of claim 10, further comprising:
configuring the antenna (502; 602) to operate at the same time as a second antenna (604),
wherein the antenna (502; 602) and the second antenna (604) are part of a phased array antenna system.

15. The structure of claim 1 or the method of claim 10, wherein the structure is configured to operate in accordance with a 60 GHz spectrum comprising a plurality of frequency ranges.

## Patentansprüche

1. Struktur, die konfiguriert ist, um in Übereinstimmung mit dem Millimeterwellen (mmWave)-Funk zu arbeiten, umfassend:
einen ersten Substratabschnitt **(404)** mit einer ersten Dicke;
einen zweiten Substratabschnitt **(406)** mit einer zweiten Dicke, die sich von der ersten Dicke unterscheidet;
eine Vielzahl von Durchkontaktierungen **(440),** die konfiguriert sind, um eine erste Masseebene **(414),** die dem ersten Substratabschnitt zugeordnet ist, und eine zweite Masseebene **(416),** die dem zweiten Substratabschnitt zugeordnet ist, zu koppeln;
eine Mikrostreifen-Zuleitung **(402)** auf einer Schicht der Struktur, wobei die Mikrostreifen-Zuleitung umfasst:
einen ersten Abschnitt, der dem ersten Substratabschnitt **(404)** zugeordnet ist und eine erste Breite aufweist;
einen zweiten Abschnitt, der dem zweiten Substratabschnitt **(406)** zugeordnet ist und eine zweite Breite aufweist, die sich von der ersten Breite unterscheidet; und
eine Verjüngung zwischen der ersten Breite und der zweiten Breite; und
eine Antenne **(502; 602)** auf der Schicht der Struktur, wobei die Antenne **(502; 602)** mit der Mikrostreifen-Zuleitung **(402)** und mindestens einem der folgenden: dem ersten Substratabschnitt **(404)** und dem zweiten Substratabschnitt **(406),** gekoppelt ist, wobei die Antenne mindestens zwei keilförmige Schlitze **(504)** umfasst, die die Antenne auf beiden Seiten der Mikrostreifen-Zuleitung **(402)** schneiden.

2. Struktur nach Anspruch **1,** wobei die Durchkontaktierungen **(440)** als Sackloch ausgebildete Durchkontaktierungen umfassen.

3. Struktur nach Anspruch **1,** wobei die Durchkontaktierungen **(440)** als Durchgangsbohrungen ausgebildete Durchkontaktierungen umfassen.

4. Struktur nach Anspruch **1,** wobei die erste Masseebene **(414)** und die zweite Masseebene **(416)** so konfiguriert sind, dass sie sich in einem Massekopplungsabschnitt **(422)** teilweise überlappen, und wobei die Durchkontaktierungen **(440)** in dem Massekopplungsabschnitt **(422)** angeordnet sind.

5. Struktur nach Anspruch **1,** wobei die Antenne **(502; 602)** eine E-förmige Kanteneinspeisungsantenne umfasst.

6. Struktur nach Anspruch **1,** wobei die mindestens zwei keilförmigen Schlitze (504) für Abgleichzwecke konfiguriert sind.

7. Struktur nach Anspruch **1,** weiter umfassend:
eine zweite Antenne **(604),** die in einem Winkel ungleich Null in Bezug auf die Antenne **(502; 602)** ausgerichtet ist.

8. Struktur nach Anspruch **1,** weiter umfassend:
eine zweite Antenne **(604),** wobei die Antenne **(502; 602)** und die zweite Antenne **(604)** als Teil eines Phased-Array-Antennensystems ausgebildet sind.

9. Struktur nach Anspruch **1,** weiter umfassend:
eine zweite Antenne **(604),** wobei die Antenne **(502; 602)** für eines der Folgenden: Senden und Empfangen, konfiguriert ist und die zweite Antenne **(604)** für das jeweilig andere aus: Senden und Empfangen, konfiguriert ist.

10. Verfahren zum Konstruieren einer Struktur, umfassend:
Koppeln **(702)** einer ersten Masseebene **(414),** die einem ersten Substratabschnitt **(404)** zugeordnet ist, und einer zweiten Masseebene **(416),** die einem zweiten Substratabschnitt **(406)** zugeordnet ist, wobei der erste Substratabschnitt **(404)** eine erste Dicke aufweist, die sich von einer zweiten Dicke des zweiten Substratabschnitts **(406)** unterscheidet;
Konstruieren **(704)** einer Mikrostreifen-Zuleitung **(402)** auf einer Schicht der Struktur, wobei die Mikrostreifen-Zuleitung **(402)** umfasst:
einen ersten Abschnitt, der dem ersten Substratabschnitt **(404)** zugeordnet ist und eine erste Breite aufweist,
einen zweiten Abschnitt, der dem zweiten Substratabschnitt **(406)** zugeordnet ist und eine zweite Breite aufweist, die sich von der ersten Breite unterscheidet, und
eine Verjüngung zwischen der ersten Breite und der zweiten Breite; und
Konstruieren einer Antenne **(502; 602)** auf der Schicht der Struktur, wobei die Antenne **(502; 602)** mit der Mikrostreifen-Zuleitung **(402)** und mindestens einem der Folgenden: dem ersten Substratabschnitt **(404)** und dem zweiten Substratabschnitt **(406),** gekoppelt ist, wobei die Antenne mindestens zwei keilförmige Schlitze **(504)** umfasst, die die Antenne auf beiden Seiten der Mikrostreifen-Zuleitung **(402)** schneiden.

11. Verfahren nach Anspruch **10,** weiter umfassend:
Koppeln der ersten Masseebene **(414)** und der zweiten Masseebene **(416)** in einem Abschnitt, in dem die erste Masseebene die zweite Masseebene überlappt, unter Verwendung einer Vielzahl von Durchkontaktierungen **(440),** die in einer Vielzahl von Reihen angeordnet sind.

12. Verfahren nach Anspruch **10,** weiter umfassend:
Koppeln einer integrierten Schaltung **(420)** mit mindestens einem der Folgenden:
der Mikrostreifen-Zuleitung **(402);** und
mindestens einem der Folgenden: dem ersten **(404)** und zweiten **(406)** Substratabschnitt.

13. Verfahren nach Anspruch **10,** weiter umfassend:
Konfigurieren der Antenne **(502; 602)** für eines der Folgenden: Senden und Empfangen; und
Konfigurieren einer zweiten Antenne **(604),** die in der Struktur enthalten ist, für das jeweilig andere aus: Senden und Empfangen.

14. Verfahren nach Anspruch **10,** weiter umfassend:
Konfigurieren der Antenne **(502; 602),** um zur gleichen Zeit wie eine zweite Antenne (604) zu arbeiten,
wobei die Antenne **(502, 602)** und die zweite Antenne **(604)** Teil eines Phased-Array-Antennensystems sind.

15. Struktur nach Anspruch **1** oder Verfahren nach Anspruch **10,** wobei die Struktur konfiguriert ist, um in Übereinstimmung mit einem 60 GHz-Spektrum zu arbeiten, das eine Vielzahl von Frequenzbereichen umfasst.

## Revendications

1. Structure configurée de manière à fonctionner conformément à une radio à ondes millimétriques, mmWave, comprenant :
une première section de substrat (404) présentant une première épaisseur ;
une seconde section de substrat (406) présentant une seconde épaisseur différente de la première épaisseur ;
une pluralité de trous de liaison (440) configurés de manière à coupler un premier plan de masse (414) associé à la première section de substrat et un second plan de masse (416) associé à la seconde section de substrat ;
une ligne d'alimentation micro-ruban (402) sur une couche de la structure, la ligne d'alimentation micro-ruban comprenant :
une première section associée à la première section de substrat (404) et présentant une première largeur ;
une seconde section associée à la seconde section de substrat (406) et présentant une seconde largeur différente de la première largeur ; et
une conicité entre la première largeur et la seconde largeur ; et
une antenne (502 ; 602) sur la couche de la structure, l'antenne (502 ; 602) étant couplée à la ligne d'alimentation micro-ruban (402) et à au moins l'une parmi la première section de substrat (404) et la seconde section de substrat (406), l'antenne comprenant au moins deux fentes cunéiformes (504) qui coupent l'antenne de part et d'autre de la ligne d'alimentation micro-ruban (402).

2. Structure selon la revendication 1, dans laquelle les trous de liaison (440) comprennent des trous borgnes.

3. Structure selon la revendication 1, dans laquelle les trous de liaison (440) comprennent des trous traversants.

4. Structure selon la revendication 1, dans laquelle le premier plan de masse (414) et le second plan de masse (416) sont configurés de manière à se chevaucher partiellement dans une section de couplage de masse (422), et dans laquelle les trous de liaison (440) sont situés dans la section de couplage de masse (422).

5. Structure selon la revendication 1, dans laquelle l'antenne (502 ; 602) comprend une antenne d'alimentation de bord en forme de E.

6. Structure selon la revendication 1, dans laquelle lesdites au moins deux fentes cunéiformes (504) sont configurées à des fins d'accord.

7. Structure selon la revendication 1, comprenant en outre :
une seconde antenne (604) orientée selon un angle non nul par rapport à l'antenne (502 ; 602).

8. Structure selon la revendication 1, comprenant en outre :
une seconde antenne (604), l'antenne (502 ; 602) et la seconde antenne (604) étant formées en tant que partie d'un système d'antennes à balayage électronique.

9. Structure selon la revendication 1, comprenant en outre :
une seconde antenne (604), l'antenne (502 ; 602) étant configurée pour l'une parmi l'émission et la réception, et la seconde antenne (604) étant configurée pour l'autre parmi l'émission et la réception.

10. Procédé de construction d'une structure comprenant les étapes consistant à :
coupler (702) un premier plan de masse (414) associé à une première section de substrat (404) et un second plan de masse (416) associé à une seconde section de substrat (406), la première section de substrat (404) présentant une première épaisseur qui est différente de la seconde épaisseur de la seconde section de substrat (406) ;
construire (704) une ligne d'alimentation micro-ruban (402) sur une couche de la structure, la ligne d'alimentation micro-ruban (402) comprenant :
une première section associée à la première section de substrat (404) et présentant une première largeur ;
une seconde section associée à la seconde section de substrat (406) et présentant une seconde largeur différente de la première largeur ; et
une conicité entre la première largeur et la seconde largeur ; et
construire une antenne (502 ; 602) sur la couche de la structure, l'antenne (502 ; 602) étant couplée à la ligne d'alimentation micro-ruban (402) et à au moins l'une parmi la première section de substrat (404) et la seconde section de substrat (406), l'antenne comprenant au moins deux fentes cunéiformes (504) qui coupent l'antenne de part et d'autre de la ligne d'alimentation micro-ruban (402).

11. Procédé selon la revendication 10, comprenant en outre l'étape consistant à :
coupler le premier plan de masse (414) et le second plan de masse (416) dans une section où le premier plan de masse chevauche le second plan de masse, en utilisant une pluralité de trous de liaison (440) agencés en une pluralité de rangées.

12. Procédé selon la revendication 10, comprenant en outre l'étape consistant à :
coupler un circuit intégré (420) à au moins l'une parmi :
la ligne d'alimentation micro-ruban (402) ; et
au moins l'une parmi la première section de substrat (404) et la seconde section de substrat (406) .

13. Procédé selon la revendication 10, comprenant en outre les étapes consistant à :
configurer l'antenne (502 ; 602) pour l'une parmi l'émission et la réception ; et
configurer une seconde antenne (604) incluse dans la structure pour l'autre parmi l'émission et la réception.

14. Procédé selon la revendication 10, comprenant en outre l'étape consistant à :
configurer l'antenne (502 ; 602) afin qu'elle fonctionne en même temps qu'une seconde antenne (604) ;
l'antenne (502 ; 602) et la seconde antenne (604) faisant partie d'un système d'antennes à balayage électronique.

15. Structure selon la revendication 1 ou procédé selon la revendication 10, la structure étant configurée de manière à fonctionner conformément à un spectre de 60 GHz comprenant une pluralité de plages de fréquences.
